Europäisches Patentamt

European Patent Office

Office européen des brevets

(19)

(11) Publication number: **0 148 771**
**B1**

(12) **EUROPEAN PATENT SPECIFICATION**

(45) Date of publication of patent specification: **12.04.89**

(51) Int. Cl.⁴: **H 03 K 17/955**

(21) Application number: **85300098.2**

(22) Date of filing: **07.01.85**

(54) Capacitance proximity sensor.

(30) Priority: **06.01.84 US 568666**

(43) Date of publication of application:
**17.07.85 Bulletin 85/29**

(45) Publication of the grant of the patent:
**12.04.89 Bulletin 89/15**

(84) Designated Contracting States:
**CH DE FR GB LI NL**

(56) References cited:
**IEEE JOURNAL OF SOLID-STATE CIRCUITS,
vol. SC-12, no. 3, June 1977, pages 217-224,
New York, US; H.J. DE MAN et al.: "A low input
capacitance voltage follower in a compatible
silicon-gate MOS-bipolar technology"
Idem
IBM TECHNICAL DISCLOSURE BULLETIN, vol.
9, no. 11, April 1967, page 1657, New York, US;
A.R. BERDING: "Low-input capacitance
isolating circuit"**

(73) Proprietor: **Cox, Harold Autrey
Highway 49 North Route 7, Box 307
Hattiesburg Mississippi 39401 (US)**

(72) Inventor: **Cox, Harold Autrey
Highway 49 North Route 7, Box 307
Hattiesburg Mississippi 39401 (US)**

(74) Representative: **Read, Matthew Charles et al
Venner Shipley & Co. 368 City Road
London EC1V 2QA (GB)**

(56) References cited:
**TOUTE L'ELECTRONIQUE, no. 439, January
1979, page 45, Paris, FR; "Amplificateur à très
faible capacité d'entrée"**
**ELECTRONICS, vol. 50, no. 2, 20th January
1977, pages 112-113, New York, US; M.V.
THOMAS: "Input capacitance feedback
improves neutralization"**

Courier Press, Leamington Spa, England.

## Description

This invention relates to a capacitance proximity sensor including a sense electrode; an elongate shielded conductor having an inner conductor coupled at one end to the sense electrode and having an outer shield conductor; a source of AC signals coupled to the shielded conductor; and detection means coupled to said source of AC signals and responsive to variations in said AC signals to detect an object in proximity to said sense electrode.

Known capacitive proximity sensors use a high impedance ac signal to detect variations in the capacitive loading of the ac signal due to the presence of an object. However, these capacitive proximity sensors suffer from a severe shortcoming in that small variations in parasitic capacitance in the associated electronic circuitry may cause faulty indications. Typically, these systems are sensitive to capacitive variations at the sense electrode of the order of .005 picoFarads. Thus, those skilled in the art will appreciate that parasitic capacitance can generate a major problem when present in the associated circuitry utilised with a proximity sensor of this type.

A second shortcoming of these capacitive proximity sensors is also related to the highly susceptible nature of the high impedance AC signal utilised. It is often necessary to dispose the electronic circuitry associated with these sensors at some distance from the sense electrode itself due to an adverse or hostile environment in which an object must be sensed.

Examples of this situation include the various hostile environments to which a semiconductor wafer must be exposed during fabrication. The necessity of utilising remote sense electrodes generates a second problem with the stray capacitance found in most electrical transmission lines. The approach typically utilised in the prior art to solve this problem is to drive an outer conductor or "guard shield" with an amplified version of the signal being guarded. This maintains both the inner conductor and the guard shield at identical electrical potentials and minimises the capacitance in the transmission line. However, the necessity of amplification introduces additional electronic circuitry which necessarily includes additional parasitic capacitance.

One approach utilised in the prior art to offset the effect of parasitic capacitance is to capacitively inject current onto the signal node being guarded, equal, and opposite to that being lost to parasitic capacitance. One major disadvantage to this approach is the difficulty in making such neutralisation independent of temperature. Parasitic capacitances in semiconductor devices are highly subject to temperature variation and may fluctuate greatly in response to these temperature variations. Thus, it is very difficult to choose a particular level of compensation for parasitic capacitance which will be effective throughout a large temperature range.

In order to overcome these disadvantages, the present invention provides a capacitance proximity sensor characterised by a first unity gain amplifier having an input, an output and an electrical power node; said source of ac signals being coupled to the second end of the inner conductor and to the input of the first unity gain amplifier; a second unity gain amplifier having an input and an output, the input of the second unity gain amplifier being coupled to the output of the first unity gain amplifier; and means coupling the output of the second unity gain amplifier to said detection means, to said electrical power node of the first amplifier and to said outer shield conductor to minimise the effects of parasitic capacitance on said detection means.

As a result, the sensor according to the invention exhibits improved temperature stability as compared with the prior art and operates satisfactorily when the shielded conductor is long such that the sense electrodes is disposed remotely from the detection means.

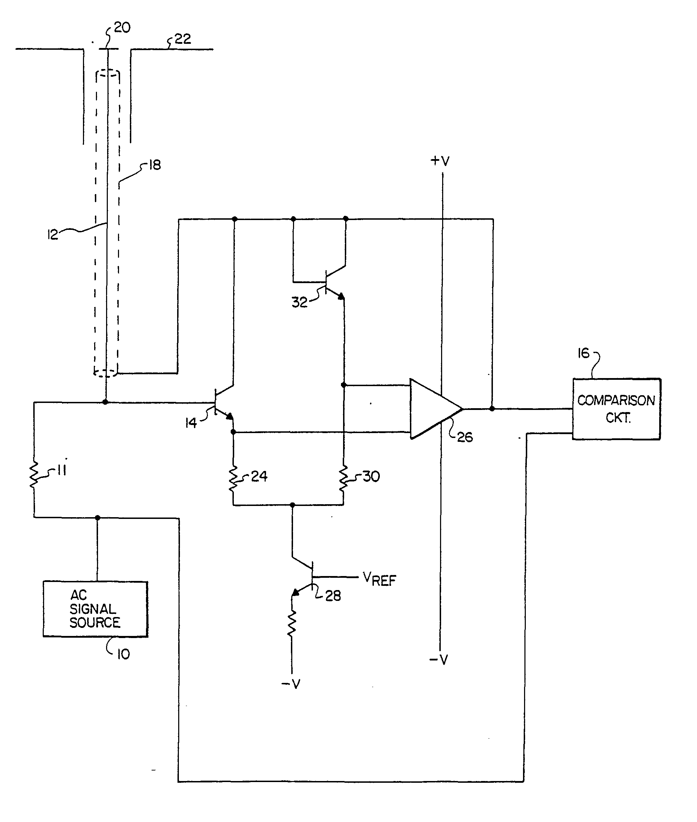

In order that the invention may be more fully understood, reference is now made to the following details description of an illustrative embodiment, and the accompanying single Figure of drawings which depicts a schematic diagram of a remote proximity sensor in accordance with the present invention.

An AC signal source 10 is utilised to provide an AC signal which is coupled to one input of phase and magnitude comparison circuit 16 and through high impedance resistor 11 to inner conductor 12 and to the base of transistor 14. Of course, those skilled in the art will appreciate that the depicted circuit is somewhat simplified in nature and that various filters, level adjusting circuits and other circuit elements will normally be interposed between ac signals source 10 and phase and magnitude comparison circuit 16.

As is illustrated, inner conductor 12 is shielded by an outer coaxial conductor 18 and is coupled at a second end thereof to a remote sense electrode 20 which is disposed within a sensor assembly 22. Again, those skilled in the art will appreciate that sensor assembly 22 will typically be built into a machine and that multiple sensor electrodes may be utilised with a single material handling machine.

In order to provide a low impedance guard signal to shield the high impedance AC signal on inner conductor 12, the high impedance AC signal is coupled to the base of transistor 14. As can be seen, transistor 14 is coupled in an emitter follower configuration and will thus function as a unity gain amplifier. The emitter bias current of transistor 14 is determined by a constant current regulator which is provided by transistor 28, which has a reference voltage applied to the based thereof. The output of the unity gain amplifier is taken at the emitter of transistor 14 and is applied to the noninverting input of amplifier 26, a standard operational amplifier operative as a differential amplifier which is also configured for unity gain. The output of operational amplifier 26 is then coupled back to coaxial conductor 18 and

2

to the collector of transistor 14. Thus, it should be obvious to those skilled in the electronics art that while the collector, emitter and base of transistor 14 are all held at the same ac potential, the input-capacitance of the amplifier thus formed will be virtually eliminated.

In addition to providing the guard signal and the electrical power source for transistor 14, the output of operational amplifier 26 is also coupled to phase and magnitude comparison circuit 16 which is utilised to detect those changes in phase and magnitude of the ac signal which will occur in response to the p resence of an object at or near sense electrode 20.

In the manner depicted herein, the capacitance sensitive signal which is applied to the base of transistor 14 is not degraded by the parasitic capacitance of the transistor amplifier circuit because each of the transistor's terminals are experiencing an identical ac signal. The emitter-to-base capacitance, $C_{4b}$, does not load the sensitive signal because of the nature of an emitter follower, in that the emitter voltage closely tracks the base voltage with only a small DC offset. Likewise, the collector-to-base capacitance $C_{cb}$ is minimised because the collector is driven by the output of operational amplifier 26 and experiences the same ac voltage as the emitter and base.

As can be seen in the figure, transistor 32 is coupled in diode configuration between the output of operational amplifier 26 and the inverting input terminal thereof. Transistor 32 is chosen to have matched characteristics with transistor 14 and is coupled in a diode configuration having its collector and base both tied to the output of operational amplifier 26. The emitter bias current of transistor 32 is also determined by the constant current source formed by transistor 28. Resistors 24 and 30 are chosen to be equal in resistance so that an identical amount of current flows through transistors 32 and 14, thus ensuring an equal voltage drop across these transistors. Because of the presence of transistor 32 coupled in this manner, the collector of transistor 14 is offset in DC voltage from the voltage at the emitter. This offset will be equal to one diode drop.

In this manner, with the collector of transistor 14 one diode drop higher than its emitter, transistor 14 will operate in its active region. And, since the base of transistor 14 is forward biased and one diode drope higher in voltage than the emitter, the base and collector of transistor 14, and the input and output of the entire circuit are at very nearly the same DC voltage. Or course, those oridinarily skilled in the art will appreciate that the DC offset function performed by transistor 32 may also be performed by utilising a diode or other DC level shifting device.

Although the invention has been described with reference to a specific embodiment, this description is not meant to be construed in a limiting sense. Various modifications of the disclosed embodiment as well as alternative embodiments of the invention falling within the scope of the claims will become apparent to persons skilled in the art upon reference to the description of the invention.

## Claims

1. A capacitance proximity sensor including a sense electrode (20); an elongate shielded conductor having an inner conductor (12) coupled at one end to the sense electrode (20) and having an outer shield conductor (18); a source (10) of ac signals coupled to the shielded conductor (12, 18); and detection means (16) coupled to said source of ac signals and responsive to variations in said ac signals to detect an object in proximity to said sense electrode (20), characterised by a first unity gain amplifier (14) having an input, an output and an electrical power node; said source (10) of ac signals being coupled to the second end of the inner conductor (12) and to the input of the first unity gain amplifier; a second unity gain amplifier (26) having an input and an output, the input of the second unity gain amplifier being coupled to the output of the first unity gain amplifier (14); and means coupling the output of the second unity gain amplifier (26) to said detection means, to said electrical power node of the first amplifier (14) and to said outer shield conductor (18) to minimise the effects of parasitic capacitance on said detection means (16).

2. A sensor according to claim 1 wherein said first unity gain amplifier (14) comprises a transistor coupled in emitter follower configuration.

3. A sensor according to claim 2 wherein the input of said first unity gain amplifier (14) comprises the base of said transistor.

4. A sensor according to claim 2 or 3 wherein said output of said first unity gain amplifier (14) comprises the emitter of said transistor.

5. A sensor according to claim 2, 3 or 4 wherein said at least one electrical power node of said first unity gain amplifier comprises the collector of said transistor.

6. A sensor according to any one of claims 2 to 5 including a constant current regulator (28) coupled to the emitter of said transistor.

7. A sensor according to any preceding claim further including means (32) for shifting the DC bias voltage of the output of said second unity gain amplifier (26).

8. A sensor according to any preceding claim wherein said second unity gain amplifier (26) comprises an differential amplifier having an inverting input, a noninverting input and an output.

9. A sensor according to claim 8 when appendant to claim 7 wherein said means for shifting the DC bias voltage of the output of said second unity gain amplifier (26) comprises a second transistor (32) coupled in diode configuration between the output of said differential amplifier (26) and said inverting input.

10. A sensor according to any preceding claim wherein said detection means includes a comparison circuit (16) arranged to compare the output of said said source (10) with the output of said second unity gain amplifier (26).

**Patentansprüche**

1. Kapazitiver Näherungssensor mit einer Abtastelektrode (20), mit einer länglichen abgeschirmten Leitung, die einen inneren Leiter (12), dessen eines Ende an die Abtastelektrode (20) angeschlossen ist, und einen äußeren Abschirmleiter (18) aufweist, mit einer Wechselspannungssignalquelle (10), die an die abgeschirmte Leitung (12, 18) angeschlossen ist, und mit einer Nachweiseinrichtung (16), die an die Wechselspannungssignalquelle angeschlossen ist und auf Änderungen der besagten Wechselspannungssignale anspricht, um ein Objekt in der Nähe der besagten Abtastelektrode (20) zu erfassen, gekennzeichnet durch einen ersten Verstärker (14) mit dem Verstärkungsfaktor Eins, der einen Eingang, einen Ausgang und einen elektrischen Leistungsanschluß aufweist, wobei diese Wechselspannungssignalquelle (10) an das zweite Ende des inneren Leiters (12) und an den Eingang des ersten Verstärkers mit dem Verstärkungsfaktor Eins angeschlossen ist und durch einen zweiten Verstärker (26) mit dem Verstärkungsfaktor Eins, der einen Eingang und einen Ausgang aufweist, wobei der Eingang dieses zweiten Verstärkers mit dem Verstärkungsfaktor Eins an den Ausgang des ersten Verstärkers (14) mit dem Verstärkungsfaktor Eins angeschlossen ist, sowie durch Mittel, die den Ausgang des zweiten Verstärkers (26) mit dem Verstärkungsfaktor Eins mit der Nachweiseinrichtung, dem elektrischen Leistungsanschluß des ersten Verstärkers (14) mit dem Verstärkungsfaktor Eins und dem besagten äußeren Abschirmleiter (18) verbinden, um die Auswirkungen parasitärer Kapazitäten auf diese Nachweiseinrichtung (16) auf ein Mindestmaß zurückzuführen.

2. Sensor nach Anspruch 1, wobei der besagte erste Verstärker (14) mit dem Verstärkungsfaktor Eins einen als Emitterfolger geschalteten Transistor aufweist.

3. Sensor nach Anspruch 2, wobei der Eingang des besagten ersten Verstärkers (14) mit dem Verstärkungsfaktor Eins die Basis des besagten Transistors beinhaltet.

4. Sensor nach Anspruch 2 oder 3, wobei der besagte Ausgang des besagten ersten Verstärkers (14) mit dem Verstärkungsfaktor Eins den Emitter des besagten Transistors beinhaltet.

5. Sensor nach Anspruch 2, 3 oder 4, wobei der besagte wenigstens eine elektrische Leistungsanschluß des besagten ersten Verstärkers mit dem Verstärkungsfaktor Eins den Kollektor des besagten Transistors beinhaltet.

6. Sensor nach irgendeinem der Ansprüche 2 bis 5, der einen Konstantstromregler (28) aufweist, der an den Emitter des besagten Transistors angeschlossen ist.

7. Sensor nach irgendeinem vorhergehenden Anspruch, der außerdem Mittel (32) zur Verlagerung der Gleichvorspannung des Ausgangs des besagten zweiten Verstärkers (26) mit dem Verstärkungsfaktor Eins aufweist.

8. Sensor nach irgendeinem vorhergehenden Anspruch, wobei der besagte zweite Verstärker (26) mit dem Verstärkungsfaktor Eins einen Differenzverstärker mit einem invertierenden Eingang, einem nichtinvertierenden Eingang sowie einem Ausgang aufweist.

9. Sensor nach Anspruch 8 in Abhängigkeit von Anspruch 7, wobei die besagten Mittel zur Verlagerung der Gleichvorspannung des Ausgangs des besagten zweiten Verstärkers (26) mit dem Verstärkungsfaktor Eins einen zweiten Transistor (32) beinhalten, der in Diodenschaltung zwischen den Ausgang des besagten Differenzverstärkers (26) und den besagten invertierenden Eingang geschaltet ist.

10. Sensor nach irgendeinem vorhergehenden Anspruch, wobei die besagte Nachweiseinrichtung einen Vergleicherschaltkreis (16) zum Vergleich des Ausgangssignales der besagten Quelle (10) mit dem Ausgangssignal des besagten zweiten Verstärkers (26) mit dem Verstärkungsfaktor Eins beinhaltet.

**Revendications**

1. Détecteur capacitif de proximité comprenant un électrode capteur (20); un conducteur blindé allongé comportant un conducteur interne (12) connecté en une extrémité à un électrode capteur (20) et comportant un conducteur blindé externe (18); une source (10) de signaux c.a. connectée au conducteur blindé (12, 18); et des dispositifs détecteurs (16) connectés à ladite source de signaux c.a. et réagissant aux variations desdits signaux c.a. pour détecter un objet à proximité dudit électrode capteur (20), caractérisé par le fait qu'un premier amplificateur de gain unité (14) se compose d'une entrée, d'une sortie et d'une connexion d'alimentation électrique; ladite source (10) de signaux c.a. étant connectée à la deuxième extrémité du conducteur interne (12) ainsi qu'à l'entrée du premier amplificateur de gain unité; un deuxième amplificateur de gain unité (26) comportant une entrée et une sortie, l'entrée du deuxième amplificateur de gain unité étant connectée à la sortie du premier amplificateur de gain unité (14); et dispositifs de connexion de la sortie du deuxième amplificateur de gain unité (26) auxdits dispositifs détecteurs, à ladite connexion d'alimentation électrique du premier amplificateur (14) et audit conducteur blindé extérieur (18) pour réduire au minimum les effets de capacité parasite sur lesdits dispositifs détecteurs (16).

2. Un capteur conforme à la revendication 1 où ledit premier amplificateur de gain unité (14) se compose d'un transistor couplé en configuration à charge d'émetteur.

3. Un capteur conforme à la revendication 2 où l'entrée dudit premier amplificateur de gain unité (14) comporte la base dudit transistor.

4. Un capteur conforme à la revendication 2 ou 3 où ladite sortie dudit amplificateur de gain unité (14) comporte l'émetteur dudit transistor.

5. Un capteur conforme à la revendication 2, 3 ou 4 où ladite connexion d'alimentation électrique, au minimum une, dudit premier amplificateur de gain unité comporte le collecteur dudit transistor.

6. Un capteur conforme à l'une des revendications 2 à 5, comprenant un régulateur constant de courant (28) couplé à l'émetteur dudit transistor.

7. Un capteur conforme à toute revendication précédente comprenant de plus des dispositifs (32) de décalage de la tension de polarisation c.c. de la sortie dudit deuxième amplificateur de gain unité (26).

8. Un capteur conforme à toute revendication précédente où ledit deuxième amplificateur de gain unité (26) comporte un amplificateur différentiel présentant une entrée inversée, une entrée sans inversion et une sortie.

9. Un capteur conforme à la revendication 8 si elle est annexée à la revendication 7 où lesdits dispositifs de décalage de la tension de polarisation c.c. de la sortie dudit deuxième amplificateur de gain unité (26) comporte un second transistor (32) couplé en configuration de diode entre la sortie dudit deuxième amplificateur différentiel (26) et ladite entrée inversée.

10. Un capteur conforme à toute revendication précédente où lesdits dispositifs détecteurs comportent un circuit comparateur (16) agencé de telle manière à pouvoir comparer la sortie de ladite source (10) à la sortie dudit deuxième amplificateur de gain unité (26).